(19) Europäisches Patentamt / European Patent Office / Office européen des brevets

(11) **EP 3 572 795 A1**

(12) **EUROPEAN PATENT APPLICATION**
published in accordance with Art. 153(4) EPC

(43) Date of publication:
**27.11.2019 Bulletin 2019/48**

(51) Int Cl.:
*G01N 21/3504* (2014.01)  *G01N 21/03* (2006.01)
*G01N 21/39* (2006.01)  *H01S 5/14* (2006.01)

(21) Application number: **18741640.9**

(22) Date of filing: **19.01.2018**

(86) International application number:
**PCT/JP2018/001590**

(87) International publication number:
**WO 2018/135619 (26.07.2018 Gazette 2018/30)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD TN**

(30) Priority:  **20.01.2017   JP 2017008937**
**07.04.2017   JP 2017076595**

(71) Applicants:
• **Sekisui Medical Co., Ltd.**
**Tokyo 103-0027 (JP)**
• **National University Corporation Nagoya University**
**Nagoya-shi, Aichi 464-8601 (JP)**

(72) Inventors:
• **IGUCHI, Tetsuo**
**Nagoya-shi**
**Aichi 464-8601 (JP)**
• **TOMITA, Hideki**
**Nagoya-shi**
**Aichi 464-8601 (JP)**
• **NISHIZAWA, Norihiko**
**Nagoya-shi**
**Aichi 464-8601 (JP)**
• **SONNENSCHEIN, Volker**
**Nagoya-shi**
**Aichi 464-8601 (JP)**
• **TERABAYASHI, Ryohei**
**Nagoya-shi**
**Aichi 464-8601 (JP)**
• **OHARA, Toshinari**
**Tokyo 103-0027 (JP)**
• **IDENO, Akira**
**Tokyo 103-0027 (JP)**
• **SATOU, Atsushi**
**Tokyo 103-0027 (JP)**
• **HASHIZUME, Kenta**
**Tokyo 103-0027 (JP)**

(74) Representative: **Hoffmann Eitle**
**Patent- und Rechtsanwälte PartmbB**
**Arabellastraße 30**
**81925 München (DE)**

(54)  **CARBON ISOTOPE ANALYSIS DEVICE AND CARBON ISOTOPE ANALYSIS METHOD**

(57)   A carbon isotope analysis device including a carbon dioxide isotope generator provided with a combustion unit that generates gas containing carbon dioxide isotope from carbon isotope, and a carbon dioxide isotope purifying unit; a spectrometer including an optical resonator having a pair of mirrors and a photodetector that determines intensity of light transmitted from the optical resonator; and a light generator including a light source, a splitter that splits light from the light source, a focusing lens that focuses light from the splitter, and a mirror that reflects light from the focusing lens and sends the light back to the light source via the focusing lens and the splitter. A carbon isotope analysis device improved in stability of a light source and a carbon isotope analysis method by use of the analysis device are provided.

FIG. 1

## Description

Technical Field

The present invention relates to a carbon isotope analysis device and a carbon isotope analysis method. In particular, the present invention relates to a radioactive carbon isotope analysis device useful for analysis of radioactive carbon isotope $^{14}C$ and a radioactive carbon isotope analysis method.

Background Art

Carbon isotope analysis has been applied to a variety of fields, including assessment of environmental dynamics based on the carbon cycle, and historical and empirical research through radiocarbon dating. The natural abundances of carbon isotopes, which may vary with regional or environmental factors, are as follows: 98.89% for $^{12}C$ (stable isotope), 1.11% for $^{13}C$ (stable isotope), and $1 \times 10^{-10}$% for $^{14}C$ (radioisotope). These isotopes, which have different masses, exhibit the same chemical behavior. Thus, artificial enrichment of an isotope of low abundance and accurate analysis of the isotope can be applied to observation of a variety of reactions.

In the clinical field, in vivo administration and analysis of a compound labeled with, for example, radioactive carbon isotope $^{14}C$ are very useful for assessment of drug disposition. For example, such a labeled compound is used for practical analysis in Phase I or Phase IIa of the drug development process. Administration of a compound labeled with radioactive carbon isotope $^{14}C$ (hereinafter may be referred to as "$^{14}C$") to a human body at a very small dose (hereinafter may be referred to as "microdose") (i.e., less than the pharmacologically active dose of the compound) and analysis of the labeled compound are expected to significantly reduce the lead time for a drug discovery process because the analysis provides findings on drug efficacy and toxicity caused by drug disposition.

Related Art

Patent Document

Patent Document 1: Japanese Patent No. 6004412

Summary of Invention

Technical Problem

The present inventors have proposed a carbon isotope analysis device that enables simple and rapid analysis of $^{14}C$, and a carbon isotope analysis method by use of the analysis device (see Patent Document 1). This has made simple and inexpensive studies of the microdose with $^{14}C$ possible.

A distributed feedback (DFB) quantum cascade laser (hereinafter may be referred to simply as "QCL".) system is increasingly demanded as one aspect of a mid-infrared (MIR) laser usable for analysis of $^{14}C$. The reason for this is because such a system is commercially available and can be simply handled with monomode emission having a broad mode-hop free tuning range of several nanometers and a typical line width of several MHz.

While QCL systems, which has the above performances, are satisfactorily used in many optical applications, the systems have been demanded to have a line width of 100 kHz or less in coupling of laser with a high-finesse optical resonator (reflectance R > 99.9%) for use in CRDS. A solution for accomplishing such a reduction in line width is, for example, a high-speed electrical signal feedback (for example, PDH lock) using a frequency discriminator, but requires a high-speed signal processing system and has the problem of being expensive, and furthermore, high bandwidth modulation is required in a laser light source.

Thus, a further improvement in stability of a light source is demanded in analysis of $^{14}C$. An object of the present invention is to provide a carbon isotope analysis device improved in stability of a light source, and a carbon isotope analysis method by use of the analysis device.

Solution to Problem

(1) A carbon isotope analysis device including a carbon dioxide isotope generator provided with a combustion unit that generates gas containing carbon dioxide isotope from carbon isotope, and a carbon dioxide isotope purifying unit; a spectrometer including an optical resonator having a pair of mirrors and a photodetector that determines intensity of light transmitted from the optical resonator; and a light generator including a light source, a splitter that splits light from the light source, a focusing lens that focuses light from the splitter, and a mirror that reflects light from the focusing lens and sends the light back to the light source via the focusing lens and the splitter.

(2) The carbon isotope analysis device according to (1), wherein the light source includes a mid-infrared quantum cascade laser.

(3) The carbon isotope analysis device according to (1) or (2), wherein the carbon isotope is radioactive carbon isotope $^{14}C$ and the carbon dioxide isotope is radioactive carbon dioxide isotope $^{14}CO_2$.

(4) The carbon isotope analysis device according to any one of (1) to (3), wherein the light having an absorption wavelength of the carbon dioxide isotope is light of a 4.5-$\mu$m wavelength range.

(5) The carbon isotope analysis device according to any one of (1) to (4), wherein the spectrometer further includes a cooler that cools the optical resonator.

(6) The carbon isotope analysis device according to any one of (1) to (5), wherein the spectrometer further includes a vacuum device that accommodates the optical resonator.

(7) The carbon isotope analysis device according to any one of (1) to (6), wherein the spectrometer further includes a vibration dampener.

(8) The carbon isotope analysis device according to any one of (1) to (7), wherein the analysis device has a detection sensitivity of about 0.1 dpm/ml to the radioactive carbon isotope $^{14}C$.

(9) The carbon isotope analysis device according to any one of Claims 1 to 8, further including a sample inlet/outlet controller including an inlet tube that connects the carbon dioxide isotope generator and the optical resonator, a three-port valve disposed on the inlet tube, closer to the carbon dioxide isotope generator, an inlet valve disposed on the inlet tube, closer to the optical resonator, an outlet tube that connects the optical resonator and a pump, and an outlet valve provided on the outlet tube.

(10) A carbon isotope analysis method, including the steps of: generating carbon dioxide isotope from carbon isotope; feeding the carbon dioxide isotope into an optical resonance atmosphere having a pair of mirrors; generating irradiation light at an absorption wavelength of the carbon dioxide isotope, from a light source; splitting light from the light source by use of a splitter, focusing the light split, on a focusing lens, reflecting the light focused, by use of a mirror, and sending the light back to the light source via the mirror and the splitter; measuring the intensity of the transmitted light generated by resonance of carbon dioxide isotope excited by the irradiation light; and calculating the concentration of the carbon isotope from the intensity of the transmitted light.

(11) The carbon isotope analysis method according to (10), wherein the carbon isotope is radioactive carbon isotope $^{14}C$ and the carbon dioxide isotope is radioactive carbon dioxide isotope $^{14}CO_2$.

(12) The carbon isotope analysis method according to (10) or (11), involving a first step of increasing pressure in a carbon dioxide generation atmosphere above atmospheric pressure, and decreasing pressure in an optical resonance atmosphere to less than atmospheric pressure; a second step of increasing temperature in the carbon dioxide generation atmosphere to a threshold temperature or higher; a third step of introducing carbon dioxide isotope into the optical resonance atmosphere at several seconds after the temperature in the carbon dioxide generation atmosphere reaches the threshold temperature; a fourth step of increasing the pressure in the carbon dioxide generation atmosphere above atmospheric pressure, and decreasing the pressure in the optical resonance atmosphere; and a fifth step of setting the pressure in the optical resonance atmosphere to 10 to 40 Torr.

(13) A light generator including a light source, a splitter that splits light from the light source, a focusing lens that focuses light from the splitter, and a mirror that reflects light from the focusing lens and sends the light back to the light source via the focusing lens and the splitter.

(14) A sample inlet/outlet controller including an inlet tube that connects a carbon dioxide isotope generator and an optical resonator; a three-port valve disposed on the inlet tube, closer to the carbon dioxide isotope generator; an inlet valve disposed on the inlet tube, closer to the optical resonator; an outlet tube that connects the optical resonator and a pump; and an outlet valve provided on the outlet tube.

(15) A carbon isotope analysis device including a spectrometer including an optical resonator having a pair of mirrors and a photodetector that determines intensity of light transmitted from the optical resonator; and a light generator including a light source, a splitter that splits light from the light source, a focusing lens that focuses light from the splitter, and a mirror that reflects light from the focusing lens and sends the light back to the light source via the focusing lens and the splitter.

Brief Description of Drawings

Figure 1 is a conceptual view of a carbon isotope analysis device.

Figure 2 illustrates absorption spectra in the 4.5-$\mu$m wavelength range of $^{14}CO_2$ and contaminant gases.

Figures 3A and 3B illustrate the principle of high-rate scanning cavity ring-down absorption spectroscopy using laser beam.

Figure 4 illustrates the dependence of CRDS absorption $\Delta\beta$ of $^{13}CO_2$ and $^{14}CO_2$ on temperature.

Figure 5 illustrates the relation between the absorption wavelength and the absorption intensity of an analytical sample.

Figure 6 is a conceptual view of a Modification of the optical resonator.

Figure 7 is a conceptual view of the embodiment of a carbon isotope analysis device.

Figure 8(a) illustrates the effect on the output of feedback in current modulation by ramp triangular wave, and Figure 8(b) illustrates the effect on the output of feedback near the vibration threshold during an increase in current.

Figure 9 illustrates a low-fineness FPI transmission signal normalized by the output depending on the presence or absence of feedback.

Figure 10 illustrates the photodiode signal of transmission from the CRD cavity in scanning of the cavity transmission line all-pass.

Figure 11 illustrates the output spectrum density of a photodiode signal averaged using periodgram. Figures 12(a) and 12(b) illustrate the changes in ring-down rate and pressure in a gas cell during introduction of a sample gas into the gas cell depending on the difference in automatic valve opening/closing operation method.

Description of Embodiments

The present inventors have made studies, and as a result, have focused on a method using optical feedback known as delayed self-injection, as an alternative of high-speed electrical signal feedback using a frequency discriminator. The inventors have found that such passive feedback can be applied to QCL, resulting in a reduction in laser line width at the minimum cost. The detail will be described below.

The present invention will now be described by way of embodiments, which should not be construed to limit the present invention. In the drawings, the same or similar reference signs are assigned to components having the same or similar functions without redundant description. It should be noted that the drawings are schematic and thus the actual dimensions of each component should be determined in view of the following description. It should be understood that the relative dimensions and ratios between the drawings may be different from each other.

(Carbon isotope analysis device)

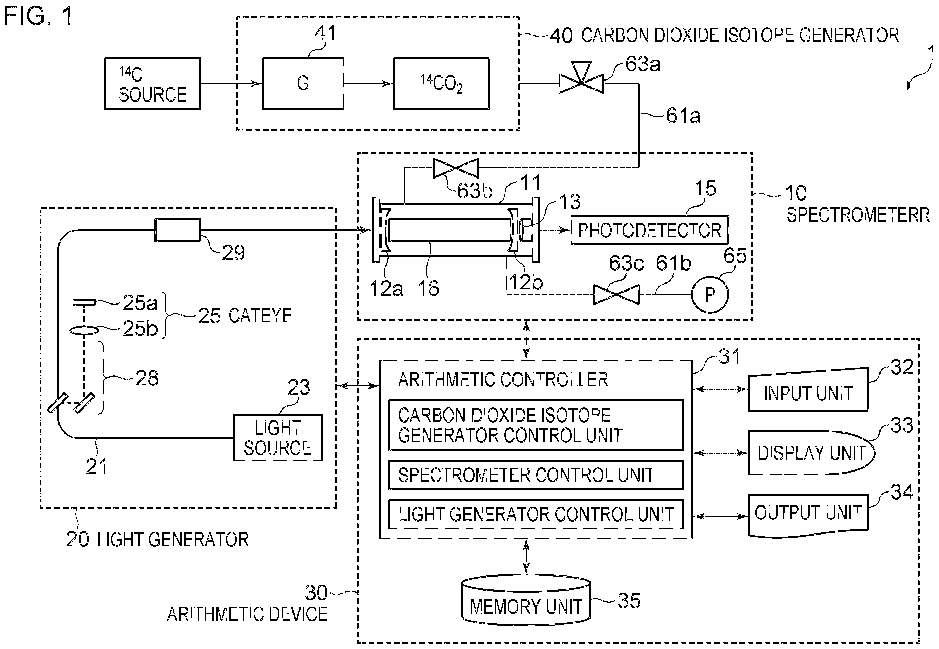

Figure 1 is a conceptual view of a carbon isotope analysis device. The carbon isotope analysis device 1 includes a carbon dioxide isotope generator 40, a light generator 20, a spectrometer 10, and an arithmetic device 30. In this embodiment, a radioisotope $^{14}$C, carbon isotope will be exemplified as an analytical sample. The light having an absorption wavelength range of the carbon dioxide isotope $^{14}$CO$_2$ generated from the radioisotope $^{14}$C is light of a 4.5-$\mu$m wavelength range. The combined selectivity of the absorption line of the target substance, the light generator, and the optical resonator mode can achieve high sensitivity (detail is omitted).

Throughout the specification, the term "carbon isotope" includes stable isotopes $^{12}$C and $^{13}$C and radioactive isotopes $^{14}$C, unless otherwise specified. In the case that the elemental signature "C" is designated, the signature indicates a carbon isotope mixture in natural abundance.

Stable isotopic oxygen includes $^{16}$O, $^{17}$O and $^{18}$O and the elemental signature "O" indicates an isotopic oxygen mixture in natural abundance.

The term "carbon dioxide isotope" includes $^{12}$CO$_2$, $^{13}$CO$_2$ and $^{14}$CO$_2$, unless otherwise specified. The signature "CO$_2$" includes carbon dioxide molecules composed of carbon isotope and isotopic oxygen each in natural abundance.

Throughout the specification, the term "biological sample" includes blood, plasma, serum, urine, feces, bile, saliva, and other body fluid and secretion; intake gas, oral gas, skin gas, and other biological gas; various organs, such as lung, heart, liver, kidney, brain, and skin, and crushed products thereof. Examples of the origin of the biological sample include all living objects, such as animals, plants, and microorganisms; preferably, mammals, preferably human beings. Examples of mammals include, but should not be limited to, human beings, monkey, mouse, rat, marmot, rabbit, sheep, goat, horse, cattle, hog, canine, and cat.

<Carbon dioxide isotope generator>

The carbon dioxide isotope generator 40 may be of any type that can convert carbon isotope to carbon dioxide isotope. The carbon dioxide isotope generator 40 should preferably have a function to oxidize a sample and to convert carbon contained in the sample to carbon dioxide.

The carbon dioxide isotope generator 40 may be a carbon dioxide generator (G) 41, for example, a total organic carbon (TOC) gas generator, a sample gas generator for gas chromatography, a sample gas generator for combustion ion chromatography, or an elemental analyzer (EA).

It is preferred to minimize the contents of at least carbon, nitrogen, and sulfur elements in the carrier gas used in an organic elemental analyzer. An example of such gas is helium (He). The flow rate of the carrier gas preferably ranges from 50 mL/min to 500 mL/min, more preferably from 100 mL/min to 300 mL/min.

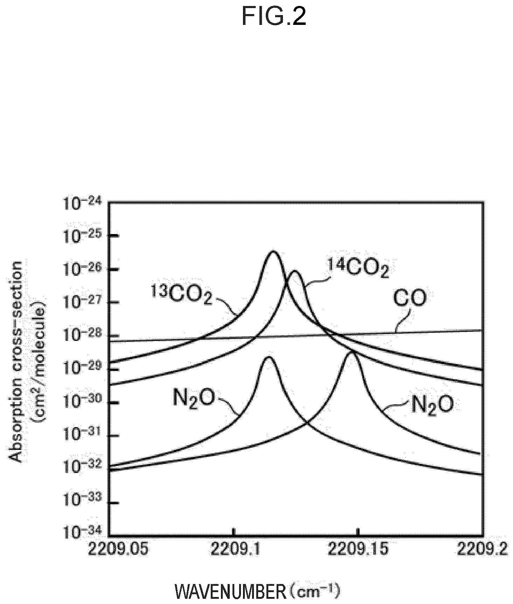

Figure 2 is 4.5-$\mu$m wavelength range absorption spectra of $^{14}$CO$_2$ and competitive gases $^{13}$CO$_2$, CO, and N$_2$O under the condition of a CO$_2$ partial pressure of 20%, a CO partial pressure of $1.0 \times 10^{-4}$% and a N$_2$O partial pressure of $3.0 \times 10^{-8}$% at 273K.

Gas containing carbon dioxide isotope $^{14}$CO$_2$ (hereinafter merely "$^{14}$CO$_2$") can be generated through combustion of a pretreated biological sample; however, gaseous contaminants, such as CO and N$_2$O are generated together with $^{14}$CO$_2$ in this process. CO and N$_2$O each exhibit a 4.5-$\mu$m wavelength range absorption spectrum as illustrated in Figure 2 and interfere with the 4.5-$\mu$m wavelength range absorption spectrum assigned to $^{14}$CO$_2$. Thus, Co and N$_2$O should preferably be removed for improved analytical sensitivity.

A typical process of removing CO and N$_2$O involves collection and separation of $^{14}$CO$_2$ as described below.
The process may be combined with a process of removing or reducing CO and N$_2$O with an oxidation catalyst or platinum catalyst.

<Spectrometer>

With reference to Figure 1, the spectrometer 10 includes an optical resonator 11 and a photodetector 15 that determines the intensity of the light transmitted from the optical resonator 11. The optical resonator or optical cavity 11 includes a cylindrical body to be filled with the target carbon dioxide isotope; a pair of highly reflective mirrors 12a and 12b (reflectance: 99.99% or more) respectively disposed at first and second longitudinal ends of the body such that the concave faces of the mirrors confront each other; a piezoelectric element 13 disposed at the second end of the body to adjust the distance between the mirrors 12a and 12b; and a cell 16 to be filled with an analyte gas. Although not illustrated, the side of the body is preferably provided with a gas inlet through which the carbon dioxide isotope is injected and a port for adjusting the pressure in the body.

A laser beam incident on and confined in the optical resonator 11 repeatedly reflects between the mirrors over several thousand to ten thousand times while the optical resonator 11 emits light at an intensity corresponding to the reflectance of the mirrors. Thus, the effective optical path length of the laser beam reaches several tens of kilometers, and a trace amount of analyte gas contained in the optical resonator can yield large absorption intensity.

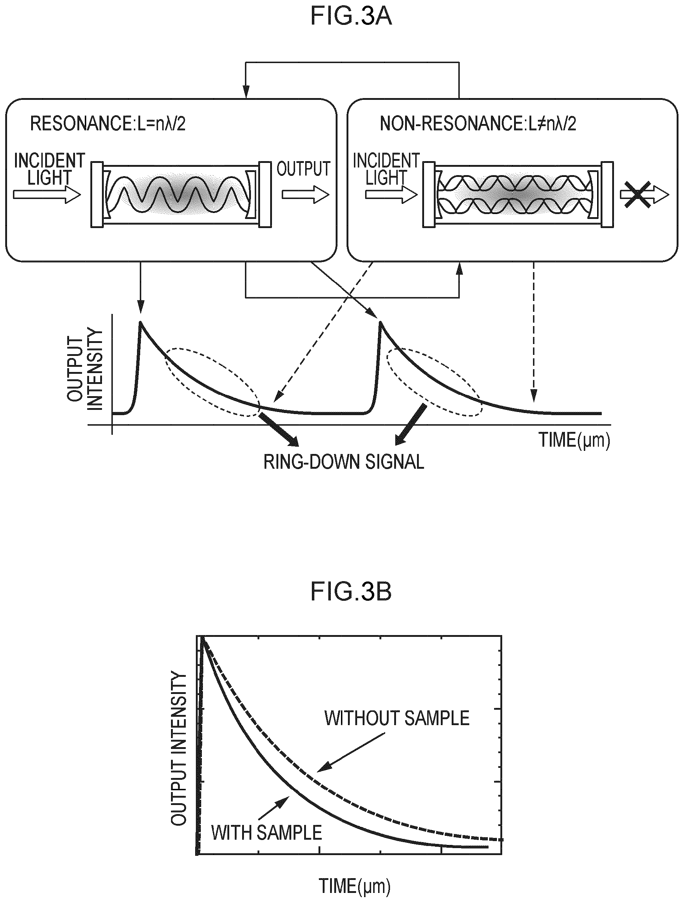

Figures 3A and 3B illustrate the principle of cavity ring-down absorption spectroscopy (hereinafter may be referred to as "CRDS") using laser beam.

As illustrated in Figure 3A, the optical resonator in a resonance state between the mirrors through operation of the piezoelectric element 13 outputs a high-intensity signal. In contrast, shielding of incident beam results in an exponential reduction in the beam accumulated in the optical resonator over time. Thus, an exponential decay signal (ring-down signal) as illustrated in Figure 3A can be observed through measurement of the intensity of light emitted from the optical resonator. Such a ring-down signal may be observed by rapid shielding of the incident laser beam with an optical switch.

In the case of the absence of a light-absorbing substance in the optical resonator, the dotted curve in Figure 3B corresponds to a time-dependent ring-down signal output from the optical resonator. In contrast, the solid curve in Figure 3B corresponds to the case of the presence of a light-absorbing substance in the optical resonator. In this case, the light decay time is shortened because of absorption of the laser beam by the light-absorbing substance during repeated reflection of the laser beam in the optical resonator. The light decay time depends on the concentration of the light-absorbing substance in the optical resonator and the wavelength of the incident laser beam. Thus, the absolute concentration of the light-absorbing substance can be calculated based on the Beer-Lambert law ii. The concentration of the light-absorbing substance in the optical resonator may be determined through measurement of a modulation in ring-down rate, which is proportional to the concentration of the light-absorbing substance.

The light leaked from the optical resonator is detected with the photodetector, and the concentration of $^{14}CO_2$ is calculated with the arithmetic device. The concentration of $^{14}C$ is then calculated from the concentration of $^{14}CO_2$.

The distance between the mirrors 12a and 12b in the optical resonator 11, the curvature radius of the mirrors 12a and 12b, and the longitudinal length and width of the body should preferably be varied depending on the absorption wavelength of the carbon dioxide isotope (i.e., analyte). The length of the optical resonator is adjusted from 1 mm to 10 m, for example.

In the case of carbon dioxide isotope $^{14}CO_2$, an increase in length of the optical resonator contributes to enhancement of the effective optical path length, but leads to an increase in volume of the gas cell, resulting in an increase in amount of a sample required for the analysis. Thus, the length of the optical resonator is preferably 10 cm to 60 cm. Preferably, the curvature radius of the mirrors 12a and 12b is equal to or slightly larger than the length of the optical resonator.

The distance between the mirrors can be adjusted by, for example, several micrometers to several tens of micrometers through the drive of the piezoelectric element 13. The distance between the mirrors can be finely adjusted by the piezoelectric element 13 for preparation of an optimal resonance state.

The mirrors 12a and 12b (i.e., a pair of concave mirrors) may be replaced with combination of a concave mirror and a planar mirror or combination of two planar mirrors that can provide a sufficient optical path.

The mirrors 12a and 12b may be composed of sapphire glass.

The cell 16 to be filled with the analyte gas preferably has a small volume because even a small amount of the analyte effectively provides optical resonance. The volume of the cell 16 may be 8 mL to 1,000 mL. The cell volume can be appropriately determined depending on the amount of a $^{14}C$ source to be analyzed. For example, the cell volume is preferably 80 mL to 120 mL for a $^{14}C$ source that is available in a large volume (e.g., urine), and is preferably 8 mL to 12 mL for a $^{14}C$ source that is available only in a small volume (e.g., blood or tear fluid).

Evaluation of stability condition of optical resonator

The $^{14}CO_2$ absorption and the detection limit of CRDS were calculated based on spectroscopic data. Spectroscopic data on $^{12}CO_2$ and $^{13}CO_2$ were retrieved from the high-resolution transmission molecular absorption database (HITRAN), and spectroscopic data on $^{14}CO_2$ were extracted from the reference "S. Dobos, et al., Z. Naturforsch, 44a, 633-639 (1989)".

A Modification ($\Delta\beta$) in ring-down rate (exponential decay rate) caused by $^{14}CO_2$ absorption ($\Delta\beta = \beta - \beta_0$ where $\beta$ is a decay rate in the presence of a sample, and $\beta_0$ is a decay rate in the absence of a sample) is represented by the following expression:

$$\Delta\beta = \sigma_{14}(\lambda, T, P)N(T, P, X_{14})c$$

where $\sigma_{14}$ represents the photoabsorption cross section of $^{14}CO_2$, N represents the number density of molecules, c represents the speed of light, and $\sigma_{14}$ and N are the function of $\lambda$ (the wavelength of laser beam), T (temperature), P (pressure), and $X_{14}$ = ratio $^{14}C/^{Total}C$.

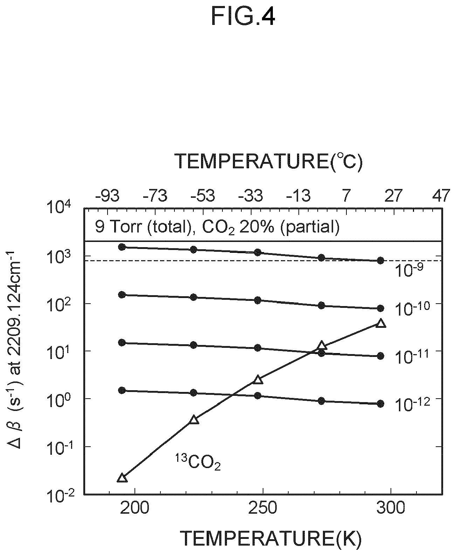

Figure 4 illustrates the dependence of calculated $\Delta\beta$ due to $^{13}CO_2$ absorption or $^{14}CO_2$ absorption on temperature. As illustrated in Figure 4, $^{13}CO_2$ absorption is equal to or higher than $^{14}CO_2$ absorption at 300K (room temperature) at a $^{14}C/^{Total}C$ of $10^{-10}$, $10^{-11}$, or $10^{-12}$, and thus the analysis requires cooling in such a case.

If a Modification ($\Delta\beta_0$) in ring-down rate (corresponding to noise derived from the optical resonator) can be reduced to a level on the order of $10^1 s^{-1}$, the analysis could be performed at a ratio $^{14}C/^{Total}C$ on the order of $10^{-11}$. Thus, cooling at about - 40°C is required during the analysis. In the case of a ratio $^{14}C/^{Total}C$ of $10^{-11}$ as a lower detection limit, the drawing suggests that requirements involve an increase (for example, 20%) in partial pressure of $CO_2$ gas due to concentration of the $CO_2$ gas and the temperature condition described above.

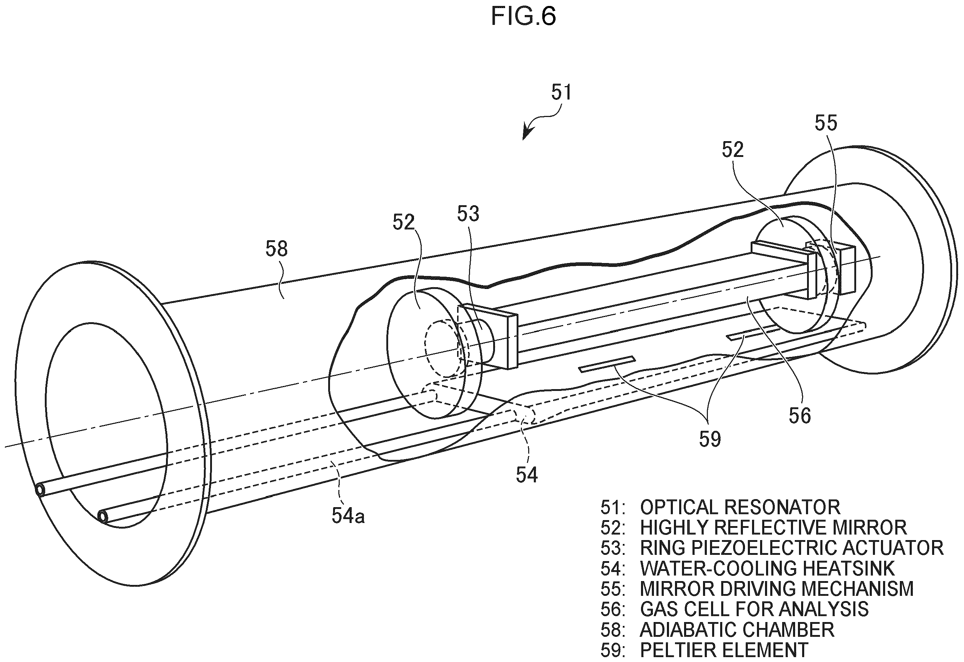

Figure 6 illustrates a conceptual view (partially cross-sectional view) of a modification of the optical resonator 11 described. As illustrated in Figure 6, an optical resonator 51 includes a cylindrical adiabatic chamber (vacuum device) 58, a gas cell 56 for analysis disposed in the adiabatic chamber 58, a pair of highly reflective mirrors 52 disposed at two ends of the gas cell 56, a mirror driving mechanism 55 disposed at one end of the gas cell 56, a ring piezoelectric actuator 53 disposed on the other end of the gas cell 56, a Peltier element 59 for cooling the gas cell 56, and a water-cooling heatsink 54 provided with a cooling pipe 54a connected to a circulation coiler (not illustrated). The water-cooling heatsink 54 can dissipate heat released from the Peltier element 59.

<Cooler>

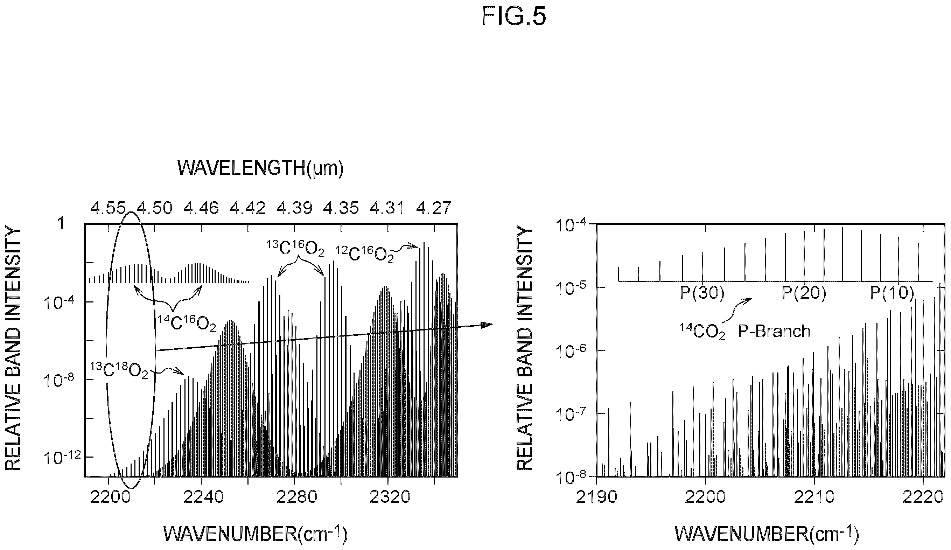

Figure 5 (cited from Applied Physics Vol.24, pp.381-386, 1981) illustrates the relationship between the absorption wavelength and absorption intensity of analytical samples $^{12}C^{16}O_2$, $^{13}C^{18}O_2$, $^{13}C^{16}O_2$, and $^{14}C^{16}O_2$. As illustrated in Figure 5, each carbon dioxide isotope has distinct absorption lines. Actual absorption lines have a finite width caused by the pressure and temperature of a sample. Thus, the pressure and temperature of a sample are preferably adjusted to atmospheric pressure or less and 273K (0°C) or less, respectively.

Since the absorption intensity of $^{14}CO_2$ has temperature dependence as described above, the temperature in the optical resonator 11 is preferably adjusted to a minimum possible level. In detail, the temperature in the optical resonator 11 is preferably adjusted to 273K (0°C) or less. The temperature may have any lower limit.

In view of cooling effect and cost, the temperature in the optical resonator 11 is adjusted to preferably 173K to 253K (-100°C to -20°C), more preferably about 233K (-40°C).

A cooler (not illustrated in Figure 1) that cools the optical resonator 11 may be provided in the spectrometer 10. Since the light absorption of $^{14}CO_2$ has temperature dependence, a decrease in temperature in the optical resonator 11 with the cooler facilitates distinction between $^{14}CO_2$ absorption lines and $^{13}CO_2$ and $^{12}CO_2$ absorption lines and enhances the $^{14}CO_2$ absorption intensity. The cooler that cools the optical resonator 11 may be, for example, a Peltier element. The cooler may be, for example, a liquid nitrogen vessel or a dry ice vessel besides the Peltier element. The Peltier element is preferred in view of a reduction in size of the spectrometer 11, whereas a liquid nitrogen vessel or a dry ice vessel is preferred in view of a reduction in production cost of the analysis device.

<Dehumidifier>

The optical resonator 11 of the Figure 1 is preferably dehumidified by a dehumidifier in cooling of the optical resonator 11.

A preferred dehumidification condition is as follows: when the CRDS analytical cell is cooled to -40°C or less (233K or less), the gas has a low moisture content not causing dewing or freezing at this temperature. Dehumidification may be carried out with a cooling means, such as a Peltier element, or by membrane separation using a polymer membrane, such as a fluorinated ion-exchange membrane, for removing moisture. A dehumidifying agent or a gas drier should preferably be positioned in a carbon dioxide generator (sample inlet unit).

Examples of the dehumidifying agent include $CaH_2$, $CaSO_4$, $Mg(ClO_4)_2$, molecular sieve, $H_2SO_4$, Sicacide, phosphorus pentoxide, Sicapent (registered trade mark), and silica gel. Among these preferred are phosphorus pentoxide, Sicapent (registered trade mark), $CaH_2$, $Mg(ClO_4)_2$ and molecular sieve. More preferred is Sicapent (registered trade mark). A preferred gas drier is Nafion (registered trade mark) drier (made by Perma Pure Inc.). The dehumidifying agent and the gas drier may be used alone or in combination. The "moisture content not causing dewing or freezing at this temperature" was determined through measurement of the dew point. In other words, dehumidification is carried out such that the dew point is -40°C or less (233K or less). The dew point may be an instantaneous dew point or an average dew point in unit time. The dew point can be measured with a commercially available dew point sensor. Examples of the dew point sensor include a Xentaur (registered trade mark) dew point sensor HTF Al2O3 (available from Mitsubishi Chemical Analytech Co., Ltd.) and Vaisala DRYCAP (registered trade mark) DM70 handy dew point sensor.

<Vacuum device>

Although not illustrated Figure 1, the optical resonator 11 may be disposed in a vacuum device. The optical resonator 11 is not exposed to external air, leading to a reduction in effect of the external temperature on the resonator 11 and an improvement in analytical accuracy.

The vacuum device may be of any type that can accommodate the optical resonator 11, apply light from the light generator 20 to the optical resonator 11, and transmit light to the photodetector.

<Sample inlet/outlet controller>

The method of introducing the carbon dioxide isotope generated in the carbon dioxide isotope generator 40 of Figure 1, into the spectrometer 10, is a flow through method or a stopped flow method. A flow through method does not need a complicated inlet mechanism and thus can provide relatively simple sample analysis, but is not suitable for measurement at high sensitivity. On the other hand, a stopped flow method can provide measurement at high sensitivity, but has the disadvantage of needing an inlet control and thus easily causing loss of a sample. The present inventors have made studies about the problem of an inlet control in a stopped flow method which can provide measurement at high sensitivity, and as a result, have led to solution of the problems by optimization of an automatic valve opening/closing system design and optimization of a method of filling with gas.

One automatic valve opening/closing system design can be a sample inlet/outlet unit 60 illustrated in Figure 1. The sample inlet/outlet controller 60 of Figure 1 includes an inlet tube 61a that connects the carbon dioxide isotope generator 40 and the optical resonator 11, a three-port valve 63a disposed upstream of the inlet tube 61a (closer to the carbon dioxide isotope generator 40), an inlet valve 63b disposed downstream of the inlet tube 61a (closer to the optical resonator 11), an outlet tube 61b that connects the optical resonator 11 and a pump 65, and an outlet valve 63c provided on the outlet tube 61b.

The cell can be filled with gas by determining the timing of opening of the three-port valve 63a and the like of the sample inlet/outlet unit 60. Specifically, control can be made at the following timings.

In a first step, the three-port valve 63a is first closed to increase the pressure in the carbon dioxide generator to atmospheric pressure or more. The inlet valve 63b and the outlet valve 63c are opened to decrease the pressure in the cell to atmospheric pressure or less, specifically, 30 Torr or less, more preferably 10 Torr or less.

In a second step, the column temperature is then increased to a threshold temperature or higher. The threshold temperature is specifically, 80°C to 200°C, preferably 90°C to 120°C, more preferably 90°C to 110°C.

When the column temperature exceeds a certain temperature, $CO_2$ gas is released in a pulsed manner, and thus the time until the $CO_2$ gas released in a pulsed manner reaches the gas cell can be seen by finding the timing where the $CO_2$ gas is released. The present inventors have found that the $CO_2$ gas reaches the gas cell after several seconds after the column temperature monitored exceeds a predetermined temperature (threshold temperature). The present inventors have specifically found that the $CO_2$ gas reaches the gas cell at a threshold temperature of 100°C after 20 seconds to 30 seconds, preferably 25 seconds to 27 seconds.

In a third step, the three-port valve 63a is opened and the inlet valve 63b is closed for introduction of gas (carbon dioxide isotope) into the gas cell, after several seconds after the column temperature reaches the threshold temperature. The time for such introduction is preferably less than 1 second, although varies depending on the changes in size and the like of the gas cell. The outlet valve 63c is here closed.

In a fourth step, the pressure in the gas cell is decreased by closing the three-port valve 63a with the inlet valve 63b being closed and increasing the pressure in the carbon dioxide generator to atmospheric pressure or more.

In the third step, the gas pressure is increased from 0 Torr to 60 Torr for a period of 1 second from opening of the three-port valve 63a for introduction of gas into the gas cell from the carbon dioxide generator, to then closing of the inlet valve. The pressure in the gas cell is here too high to be suitable for absorption line determination. Thus, the pressure in the gas cell is decreased in the fourth step.

In a fifth step, the outlet valve 63c is opened until the pressure in the gas cell reaches about 10 to 40 Torr (about 1 second), and thereafter the outlet valve 63c is closed. The pressure in the gas cell is preferably 18 to 22 Torr.

The pressure in the gas cell is gradually decreased because gas in the gas cell is discharged by opening the outlet valve 63c with the inlet valve 63b being closed. After the pressure in the gas cell is decreased to about 20 Torr, the outlet valve 63c is closed.

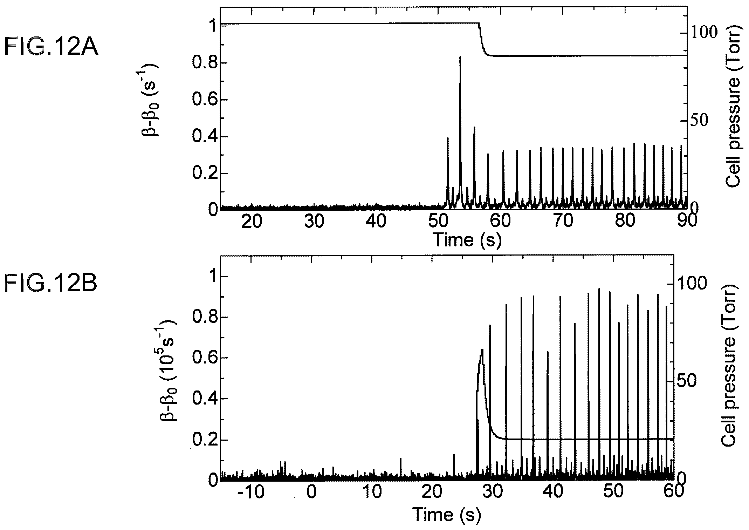

Figures 12(a) and 12(b) illustrate the relation between the changes in ring-down rate and pressure in the gas cell in the optical resonator in the case of use of the sample inlet/outlet controller of the present invention.

The top (Figure 12(a)) illustrates the relation between the changes in ring-down rate and pressure in the gas cell in the case where the three-port valve 63a, the inlet valve 63b and the outlet valve 63c are opened for introduction a carrier gas from the carbon dioxide generator before release of $CO_2$ gas, into the gas cell, and the three-port valve 63a, the inlet valve 63b and the outlet valve 63c are closed at the same time as soon as the $CO_2$ gas is released and then reaches the gas cell. The pressure in the cell after introduction of the $CO_2$ gas is

as high as about 60 Torr, and is not suitable for absorption line determination. Additionally, the carrier gas is present in the cell when the $CO_2$ gas reaches the gas cell, and thus the $CO_2$ gas is closed in the gas cell and thus diluted with the carrier gas, resulting in a reduction in concentration of the $CO_2$ gas in the cell and a decrease in ring-down signal proportional to the absorption intensity of the $CO_2$ gas.

In comparison with this, the bottom (Figure 12(b)) indicates that the pressure in the cell after introduction of the $CO_2$ gas is about 20 Torr in appropriate automatic opening/closing of the valves by use of the sample inlet/outlet controller of the present invention. The pressure is suitable for absorption line determination and causes almost no dilution with the carrier gas, resulting in no reduction in concentration of the $CO_2$ gas in the cell and no decrease in ring-down signal.

The data illustrated in Figure 12 is obtained by always sweeping the wavelength of the laser and acquiring absorption line spectra of $CO_2$ once every about 5 seconds.

<Light generator>

The light generator 20 of Figure 1 may be of any type that can generate light having the absorption wavelength of the carbon dioxide isotope. In this embodiment, a compact light generator will be described that can readily generate light of a 4.5-$\mu$m wavelength range, which is the absorption wavelength of radioactive carbon isotope $^{14}$C.

The light generator 20 includes a light source 23, a splitter (delay line) 28 that splits light from the light source 23, a focusing lens 25b that focuses light from the splitter 28, and CATEYE 25 including a mirror 25a that reflects light from the focusing lens 25 and sends the light back to the light source 23 via the focusing lens 25 and the splitter 28. The light generator 20 further includes an optical separator 29.

The CATEYE 25 decreases the dependence of back reflection on the adjustment of angle, thereby enabling easy re-incidence to QCL to be made. The optical separator 29 enables light to be shielded.

The light source 23 may be a mid-infrared quantum cascade laser (Quantum Cascade Laser: QCL).

It is preferred that the first optical fiber 21 can transmit high intensity of ultrashort light pulses without deterioration of the optical properties of the pulses. The first optical fiber 21 should preferably be composed of fused silica.

<Arithmetic device>

The arithmetic device 30 of Figure 1 may be of any type that can determine the concentration of a light-absorbing substance in the optical resonator based on the decay time and ring-down rate and calculate the concentration of the carbon isotope from the concentration of the light-absorbing substance.

The arithmetic device 30 includes an arithmetic controller 31, such as an arithmetic unit used in a common computer system (e.g., CPU); an input unit 32, such as a keyboard or a pointing device (e.g., a mouse); a display unit 33, such as an image display (e.g., a liquid crystal display or a monitor); an output unit 34, such as a printer; and a memory unit 35, such as a ROM, a RAM, or a magnetic disk.

In the case that the carbon isotope analysis device 1 is used in a microdose test, the prospective detection sensitivity to the radioactive carbon isotope $^{14}$C in the sample is approximately 0.1 dpm/ml. Such a detection sensitivity "0.1 dpm/ml" requires not only use of "narrow-spectrum laser" as a light source, but also the stability of wavelength or frequency of the light source. In other words, the requirements include no deviation from the wavelength of the absorption line and a narrow line width. In this regard, the carbon isotope analysis device 1 has an advantage in that the analysis device can determine a low concentration of radioactive carbon isotope in the analyte.

The detection sensitivity of the radioactive carbon isotope $^{14}$C in the sample of the carbon isotope analysis device 1 is about "0.1 dpm/ml", more preferably "0.1 dpm/ml" or less.

The earlier literature (Hiromoto Kazuo et al., "Designing of 14C continuous monitoring based on cavity ring down spectroscopy", preprints of Annual Meeting, the Atomic Energy Society of Japan, March 19, 2010, p. 432) discloses determination of the concentration of $^{14}$C in carbon dioxide by CRDS in relation to monitoring of the concentration of spent fuel in atomic power generation. Although the signal processing using the fast Fourier transformation (FFT) disclosed in the literature has a high processing rate, the fluctuation of the baseline increases, and thus a detection sensitivity of 0.1 dpm/ml cannot be readily achieved.

Although the carbon isotope analysis device of the present invention has been described with reference to the embodiment, the configuration of the carbon isotope analysis device should not be limited to the analysis device described above, and various modifications may be made. Several modifications of the carbon isotope analysis device will now be described by focusing on modified points.

The spectrometer may further be provided with a vibration damper. The vibration damper can prevent a perturbation in distance between the mirrors due to the external vibration, resulting in an improvement in analytical accuracy. The vibration damper may be an impact absorber (polymer gel) or a seismic isolator. The seismic isolator may be of any type that can provide the spectrometer with vibration having a phase opposite to that of the external vibration.

In the aforementioned embodiment, the distance between the mirrors is adjusted with the piezoelectric element 13 for generation of ring-down signals in the spectrometer 10. For generation of ring-down signals, a light shield may be provided in the light generator 20 for ON/OFF control of light incident on the optical resonator 11. The light shield may be of any type that can promptly block light having the absorption wavelength of the carbon dioxide isotope. The light shield is, for example, an optical switch. The excitation light should be blocked within a time much shorter than the decay time of light in the optical resonator.

(Pretreatment of biological sample)

The pretreatment of the biological sample is categorized into a step of removing carbon sources derived from biological objects and a step of removing or separating the gaseous contaminant in a broad sense. In this embodiment, the step of removing carbon sources derived from biological objects will now be mainly described.

A microdose test analyzes a biological sample, for example, blood, plasma, urine, feces, or bile containing an ultratrace amount of $^{14}C$ labeled compound. Thus, the biological sample should preferably be pretreated to facilitate the analysis. Since the ratio $^{14}C/^{Total}C$ of $^{14}C$ to total carbon in the biological sample is one of the parameters determining the detection sensitivity in the measurement due to characteristics of the CRDS unit, it is preferred to remove the carbon source derived from the biological objects contained in the biological sample.

(Carbon isotope analysis method)

The analysis of radioisotope $^{14}C$ as an example of the analyte will now be described.

(A) Carbon isotope analysis device 1 illustrated in Figure 1 is provided. Biological samples, such as blood, plasma, urine, feces, and bile, containing $^{14}C$ are also prepared as radioisotope $^{14}C$ sources.
(B) The biological sample is pretreated to remove protein and thus to remove the biological carbon source. Examples of deproteinization include insolubilization of protein with acid or organic solvent; ultrafiltration and dialysis based on a difference in molecular size; and solid-phase extraction. As described below, deproteinization with organic solvent is preferred, which can extract the $^{14}C$ labeled compound and in which the organic solvent can be readily removed after treatment.

The deproteinization with organic solvent involves addition of the organic solvent to a biological sample to insolubilize protein. The $^{14}C$ labeled compound adsorbed on the protein is extracted to the organic solvent in this process. To enhance the recovery rate of the $^{14}C$ labeled compound, the solution is transferred to another vessel and fresh organic solvent is added to the residue to further extract the labeled compound. The extraction operations may be repeated several times. In the case that the biological sample is feces or an organ such as lung, which cannot be homogeneously dispersed in organic solvent, the biological sample should preferably be homogenized. The insolubilized protein may be removed by centrifugal filtration or filter filtration, if necessary.

The organic solvent is then removed by evaporation to yield a dry $^{14}C$ labeled compound. The carbon source derived from the organic solvent can thereby be removed. Preferred examples of the organic solvent include methanol (MeOH), ethanol (EtOH), and acetonitrile (ACN). Particularly preferred is acetonitrile.

(C) The pretreated biological sample was combusted to generate gas containing carbon dioxide isotope $^{14}CO_2$ from the radioactive isotope $^{14}C$ source. $N_2O$ and CO are then removed from the resulting gas.
(D) Moisture is removed from the resultant $^{14}CO_2$ gas. For example, moisture is preferably removed from the $^{14}CO_2$ gas in the carbon dioxide isotope generator 40 by allowing the $^{14}CO_2$ gas to pass through a desiccant (e.g., calcium carbonate) or cooling the $^{14}CO_2$ gas for moisture condensation. Formation of ice or frost on the optical resonator 11, which is caused by moisture contained in the $^{14}CO_2$ gas, may lead to a reduction in reflectance of the mirrors, resulting in low detection sensitivity. Thus, removal of moisture improves analytical accuracy. The $^{14}CO_2$ gas is preferably cooled and then introduced into the spectrometer 10 for the subsequent spectroscopic process. Introduction of the $^{14}CO_2$ gas at room temperature significantly varies the temperature of the optical resonator, resulting in a reduction in analytical accuracy.
(E) The $^{14}CO_2$ gas is fed into the optical resonator 11 having the pair of mirrors 12a and 12b. The $^{14}CO_2$ gas is preferably cooled to 273K (0°C) or less to enhance the absorption intensity of excitation light. The optical resonator 11 is preferably maintained under vacuum because a reduced effect of the external temperature on the optical resonator improves analytical accuracy.
(F) A laser beam is generated from the light source 23, and the resulting light is transmitted through the optical fiber 21. The light source to be used is preferably QCL. The light from the light source 23 is split with the splitter 28, the light split is focused on the focusing lens 25b, and the light focused is reflected with the mirror 25a and sent back to the light source 23 via the mirror 25a and the splitter 28 (feedback step).
The foregoing generates excitation light of 4.5 $\mu$m, which is the absorption wavelength of the carbon dioxide isotope $^{14}CO_2$.
(G) The carbon dioxide isotope $^{14}CO_2$ is in resonance with the light. To improve analytical accuracy, the external vibration of the optical resonator 11 is preferably reduced by a vibration absorber to prevent a perturbation in distance between the mirrors 12a and 12b. During resonance, the downstream end of the first optical fiber 21 should preferably abut on the mirror 12a to prevent the light from coming into contact with air. The intensity of light transmitted from the optical resonator 11 is then determined. To generate ring-down signals, the length of the resonator is changed at a high speed or light incident to the optical resonator 11 is shielded so as to turn resonance to non-resonance. The light incident to the optical resonator 11 is here shielded by the optical separator (switch) 29.

(H) The concentration of carbon isotope $^{14}C$ is calculated from the intensity of the transmitted light.

(Other embodiments)

Although the embodiment of the present invention has been described above, the descriptions and drawings as part of this disclosure should not be construed to limit the present invention. This disclosure will enable those skilled in the art to find various alternative embodiments, examples, and operational techniques.

The carbon isotope analysis device according to the embodiment has been described by focusing on the case where the analyte as a carbon isotope is radioisotope $^{14}C$. The carbon isotope analysis device can analyze stable isotopes $^{12}C$ and $^{13}C$ besides radioisotope $^{14}C$. In such a case, excitation light of 2 $\mu m$ or 1.6 $\mu m$ is preferably used in, for example, absorption line analysis of $^{12}CO_2$ or $^{13}CO_2$ based on analysis of $^{12}C$ or $^{13}C$.

In the case of absorption line analysis of $^{12}CO_2$ or $^{13}CO_2$, the distance between the mirrors is preferably 10 to 60 cm, and the curvature radius of the mirrors is preferably equal to or longer than the distance therebetween.

Although the carbon isotopes $^{12}C$, $^{13}C$, and $^{14}C$ exhibit the same chemical behaviors, the natural abundance of $^{14}C$ (radioisotope) is lower than that of $^{12}C$ or $^{13}C$ (stable isotope). Artificial enrichment of the radioisotope $^{14}C$ and accurate analysis of the isotope can be applied to observation of a variety of reaction mechanisms.

A medical diagnostic device or environmental measuring device including the configuration described above in the embodiment can be produced as in the carbon isotope analysis device. The light generator described in the embodiments can also be used as a measuring device.

As described above, the present invention certainly includes, for example, various embodiments not described herein. Thus, the technological range of the present invention is defined by only claimed elements of the present invention in accordance with the proper claims through the above descriptions.

Examples

The present invention will be described in more detail with reference to Examples below. The apparatus used in Examples may be any type, and other apparatus may be used as long as such an apparatus has the same function.

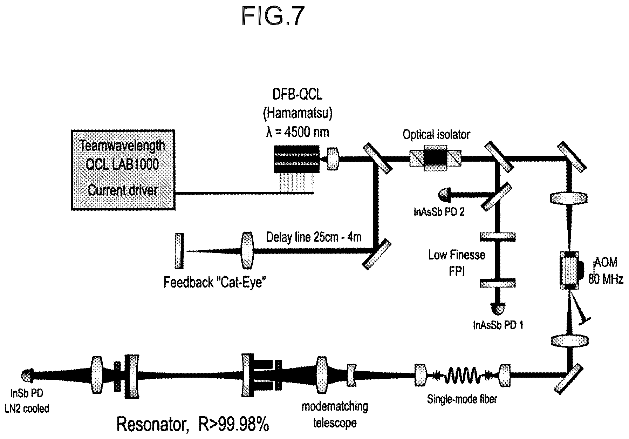

Figure 7 illustrates a schematic view of a QCL system. The system is designed for not only studies of optical feedback, but also CRDS measurement. The entire laser system including a FPI (optical resonator), an acousto-optical modulator (AOM) and an optical fiber coupling is incorporated into an optical stage of 60 × 60 cm, for optical experiments, and the optical fiber coupling is incorporated into another optical stage of 60 × 60 cm, for optical experiments, and is easily potable without realignment.

2. Experiment procedure

Figure 7 illustrates a schematic view of an optical layout. DFB-QCL (L12004-2209H-C manufactured by Hamamatsu Photonics K.K.) was operated by a low noise current driver (Teamwavelength, QCL-LAB1000), thereby operating the current applied, to thereby modulate the wavelength of laser. A laser beam was partially extracted by a 50/50 beam splitter (value of reflectance actually measured, R = 40%) for feedback. Such light was focused on a gold mirror (so-called "CATEYE" serving as a reflection mirror) after a variable delay path of 25 cm to 4 m. The CATEYE can decrease the dependence of back reflection on the adjustment of angle, thereby allowing for easy re-incidence to QCL.

In order to examine the effects of feedback on the laser output and the change in frequency, a Fabry-Perot resonator (FSR = 1.86 GHz, fineness 4.5) configured from two 50:50 beam splitters was installed.

Two InAsSb photodiodes (Hamamatsu Photonics K.K., P13243-011MA) were used which were low in cost and wide in band (> 1 MHz) and which could be operated at room temperature. One thereof was used for reference of an output power and the other thereof was used for detection of transmitted light from a low-fineness FPI. The results provided the signal of the transmitted light from FPI in scanning of a QCL current, which was normalized by the intensity of output light.

After coupling with a single mode fiber, the laser beam was introduced into a CRD resonator (reflectance > 99.98, length = 30 cm, the fineness experimentally evaluated was about 10,000). The length of the CRD resonator was scanned by a piezoelectric element. The light was transmitted through the resonator only in the case where the resonance condition of the resonator was near the length of the resonator $L = n\lambda/2$ (n = 1,2..., $\lambda$: wavelength).

The laser was rapidly shielded by an acousto-optical modulator (AOM, operating as a high-speed optical switch) in typical ring-down signal measurement.

The AOM was normally "ON" in evaluation of a laser line width shown below. The transmitted light was subjected to measurement with a liquid nitrogen cooling InSb detector, and was amplified by a high-speed current amplifier.

3. Effect of feedback

The QCL current was modulated by applying a ramp triangular wave voltage to the input of modulation of the current driver. A beam block was attached just behind a focusing lens of a CATEYE reflecting device, for the case of no optical feedback.

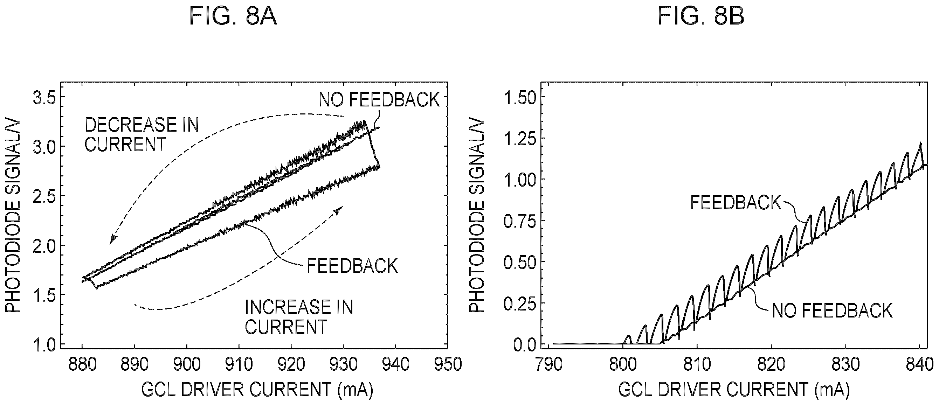

Figure 8 illustrates the dependence of the output on the current applied. The effect of feedback is very obviously seen. Not only a strong hysteresis effect of feedback in a reduction in current, but also the variation in output by mode hopping of QCL occurs every FSR of an external cavity with the feedback in Figure 8(a). As illustrated in Figure 8(b), the vibration threshold of the current is reduced by several percentages. Such a reduction is monitored to thereby easily optimize the level of feedback, because increased feedback leads to a reduced vibration threshold.

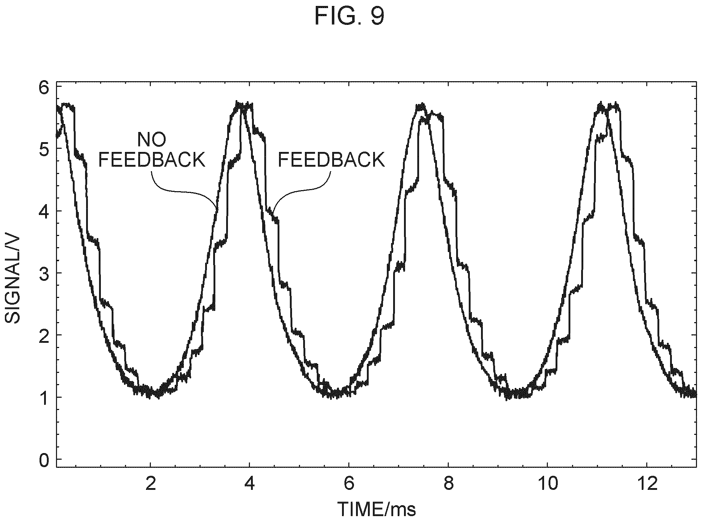

Figure 9 illustrates the dependence on the current applied and the output of the FPI transmission signal. Mode hopping of QCL is clearly observed by FPI waveform. A slight usual shift of vibration frequency is observed in the results of FPI, and seems to be due to heat from the output re-injected.

The effect of feedback on the laser line width was evaluated by monitoring the transmitted light from the CRD resonator. Thus, the current of QCL was fixed to 850 mA, and the length of the resonator was slowly scanned in the range of peak of the transmitted light.

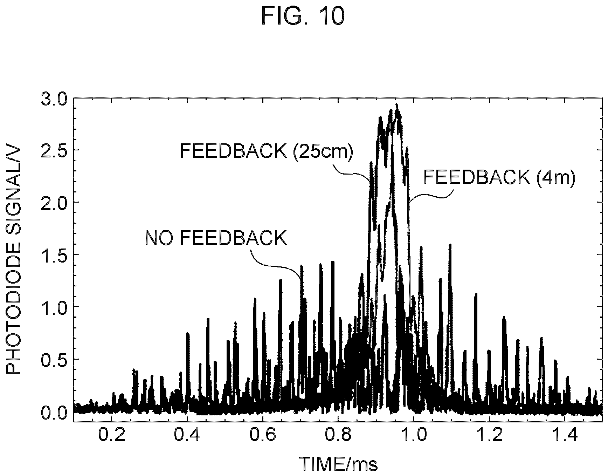

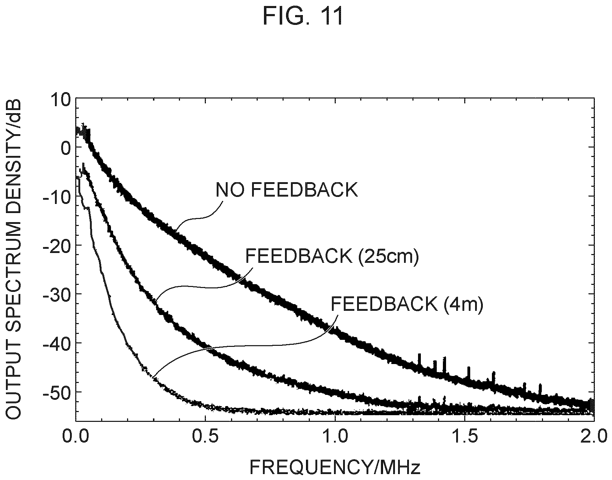

Figure 10 illustrates peaks of transmitted light from the CRD resonator. The information on expansion of oscillation frequency due to modulation of the signal intensity by a steep dependence of frequency in the vicinity of resonance is obtained. In the case of no feedback, many spikes are present in a signal over a wide range. It indicates that the frequency of QCL varies at a high speed, and the variation is possibly due to a noise of the QCL current driver used. In contrast, in the case of any feedback present, the signal of the transmitted light of QCL exhibits a clear single peak, and it can be said that only a slight variation is exhibited. The line width in the feedback present is estimated to be approximately comparable to the width of a peak with respect to transmission properties of the CRD resonator, about 50 kHz. It can be said from this that the feedback dramatically decreases the line width. The power density of the noise is expressed as the average of one hundred transmission events (Figure 11). The variation in intensity in a high frequency region is generally decreased by low path characteristics of a resonator. The noise level was decreased by about 30 dB in a frequency region of 100 kHz or more by optical feedback. While a longer feedback path appeared to lead to further stabilization of laser, the noise in a low frequency region (acoustic frequency region <5 kHz) was increased. Such an increase in low frequency region seems to be due to acoustic oscillation of a feedback path, air flow, and instability of the temperature.

Reference Signs List

| | |
|---|---|
| 1 | carbon isotope analysis device |
| 10 | spectrometer |
| 11 | optical resonator |
| 12 | mirror |
| 13 | piezoelectric element |
| 15 | photodetector |
| 16 | cell |
| 20 | light generator |
| 21 | optical fiber |
| 23 | light source |
| 25 | CATEYE |
| 25a | mirror |
| 25b | focusing lens |
| 29 | optical separator |
| 30 | arithmetic device |
| 40 | carbon dioxide isotope generator |
| 60 | sample inlet/outlet controller |
| 61a | inlet tube |
| 61b | outlet tube 61b |
| 63a | three-port valve |
| 63b | inlet valve |
| 63c | outlet valve |
| 65 | pump |

Claims

1. A carbon isotope analysis device comprising:

a carbon dioxide isotope generator comprising a combustion unit that generates gas containing carbon dioxide isotope from carbon isotope, and a carbon dioxide isotope purifying unit;
a spectrometer comprising an optical resonator having a pair of mirrors and a photodetector that determines intensity of light transmitted from the optical resonator; and
a light generator comprising a light source, a splitter that splits light from the light source, a focusing lens that focuses light from the splitter, and a mirror that reflects light from the focusing lens and sends the light back to the light source via the focusing lens and the splitter.

2. The carbon isotope analysis device according to claim 1, wherein the light source comprises a mid-infrared quantum cascade laser.

**3.** The carbon isotope analysis device according to claim 1 or 2, wherein the carbon isotope is radioactive carbon isotope $^{14}C$ and the carbon dioxide isotope is radioactive carbon dioxide isotope $^{14}CO_2$.

**4.** The carbon isotope analysis device according to any one of Claims 1 to 3, wherein the light having an absorption wavelength of the carbon dioxide isotope is light of a 4.5-$\mu$m wavelength range.

**5.** The carbon isotope analysis device according to any one of Claims 1 to 4, wherein the spectrometer further comprises a cooler that cools the optical resonator.

**6.** The carbon isotope analysis device according to any one of Claims 1 to 5, wherein the spectrometer further comprises a vacuum device that accommodates the optical resonator.

**7.** The carbon isotope analysis device according to any one of Claims 1 to 6, wherein the spectrometer further comprises a vibration dampener.

**8.** The carbon isotope analysis device according to any one of Claims 1 to 7, wherein the analysis device has a detection sensitivity of about 0.1 dpm/ml to the radioactive carbon isotope $^{14}C$.

**9.** The carbon isotope analysis device according to any one of Claims 1 to 8, further comprising a sample inlet/outlet controller comprising
an inlet tube that connects the carbon dioxide isotope generator and the optical resonator,
a three-port valve disposed on the inlet tube, closer to the carbon dioxide isotope generator,
an inlet valve disposed on the inlet tube, closer to the optical resonator,
an outlet tube that connects the optical resonator and a pump, and
an outlet valve provided on the outlet tube.

**10.** A carbon isotope analysis method, comprising the steps of:

generating carbon dioxide isotope from carbon isotope;
feeding the carbon dioxide isotope into an optical resonance atmosphere having a pair of mirrors;
generating irradiation light at an absorption wavelength of the carbon dioxide isotope, from a light source;
splitting light from the light source by use of a splitter, focusing the light split, on a focusing lens, reflecting the light focused, by use of a mirror, and sending the light back to the light source via the mirror and the splitter,

measuring the intensity of the transmitted light generated by resonance of carbon dioxide isotope excited by the irradiation light, and
calculating the concentration of the carbon isotope from the intensity of the transmitted light.

**11.** The carbon isotope analysis method according to claim 10, wherein the carbon isotope is radioactive carbon isotope $^{14}C$ and the carbon dioxide isotope is radioactive carbon dioxide isotope $^{14}CO_2$.

**12.** The carbon isotope analysis method according to claim 10 or 11, comprising
a first step of increasing pressure in a carbon dioxide generation atmosphere above atmospheric pressure, and decreasing pressure in an optical resonance atmosphere to less than atmospheric pressure,
a second step of increasing temperature in the carbon dioxide generation atmosphere to a threshold temperature or higher,
a third step of introducing carbon dioxide isotope into the optical resonance atmosphere at several seconds after the temperature in the carbon dioxide generation atmosphere reaches the threshold temperature,
a fourth step of increasing the pressure in the carbon dioxide generation atmosphere above atmospheric pressure, and decreasing the pressure in the optical resonance atmosphere, and
a fifth step of setting the pressure in the optical resonance atmosphere to 10 to 40 Torr.

**13.** A light generator comprising a light source, a splitter that splits light from the light source, a focusing lens that focuses light from the splitter, and a mirror that reflects light from the focusing lens and sends the light back to the light source via the focusing lens and the splitter.

**14.** A sample inlet/outlet controller comprising
an inlet tube that connects a carbon dioxide isotope generator and an optical resonator,
a three-port valve disposed on the inlet tube, closer to the carbon dioxide isotope generator,
an inlet valve disposed on the inlet tube, closer to the optical resonator,
an outlet tube that connects the optical resonator and a pump, and
an outlet valve provided on the outlet tube.

**15.** A carbon isotope analysis device comprising:

a spectrometer comprising an optical resonator having a pair of mirrors and a photodetector that determines intensity of light transmitted from the optical resonator; and
a light generator comprising a light source, a splitter that splits light from the light source, a focusing lens that focuses light from the splitter, and a mirror that reflects light from the focusing lens and sends the light back to the light source via the focusing lens and the splitter.

FIG. 1

EP 3 572 795 A1

FIG.2

# FIG.3A

RESONANCE:L=nλ/2

INCIDENT LIGHT

OUTPUT

NON-RESONANCE:L≠nλ/2

INCIDENT LIGHT

OUTPUT INTENSITY

TIME(μm)

RING-DOWN SIGNAL

# FIG.3B

OUTPUT INTENSITY

WITHOUT SAMPLE

WITH SAMPLE

TIME(μm)

# FIG.4

TEMPERATURE(°C)

Δβ (s⁻¹) at 2209.124cm⁻¹

9 Torr (total), $CO_2$ 20% (partial)

$10^{-9}$

$10^{-10}$

$10^{-11}$

$10^{-12}$

$^{13}CO_2$

TEMPERATURE(K)

FIG.5

EP 3 572 795 A1

# FIG.6

51: OPTICAL RESONATOR
52: HIGHLY REFLECTIVE MIRROR
53: RING PIEZOELECTRIC ACTUATOR
54: WATER-COOLING HEATSINK
55: MIRROR DRIVING MECHANISM
56: GAS CELL FOR ANALYSIS
58: ADIABATIC CHAMBER
59: PELTIER ELEMENT

EP 3 572 795 A1

FIG.7

FIG. 8A

FIG. 8B

EP 3 572 795 A1

FIG. 9

FIG. 10

FIG. 11

FIG.12A

FIG.12B

## INTERNATIONAL SEARCH REPORT

| | International application No. |
|---|---|
| | PCT/JP2018/001590 |

A. CLASSIFICATION OF SUBJECT MATTER
Int.Cl. G01N21/3504(2014.01)i, G01N21/03(2006.01)i, G01N21/39(2006.01)i,
H01S5/14(2006.01)i

According to International Patent Classification (IPC) or to both national classification and IPC

B. FIELDS SEARCHED

Minimum documentation searched (classification system followed by classification symbols)
Int.Cl. G01N21/3504, G01N21/03, G01N21/39, H01S5/14

Documentation searched other than minimum documentation to the extent that such documents are included in the fields searched
| | |
|---|---|
| Published examined utility model applications of Japan | 1922-1996 |
| Published unexamined utility model applications of Japan | 1971-2018 |
| Registered utility model specifications of Japan | 1996-2018 |
| Published registered utility model applications of Japan | 1994-2018 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | WO 2016/140254 A1 (NAGOYA UNIVERSITY) 09 September 2016 (Family: none) | 1-15 |
| A | JP 2016-156752 A (NAGOYA UNIVERSITY) 01 September 2016 (Family: none) | 1-15 |
| A | JP 2016-156706 A (NAGOYA UNIVERSITY) 01 September 2016 (Family: none) | 1-15 |

☒ Further documents are listed in the continuation of Box C.     ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 23 March 2018 (23.03.2018) | 10 April 2018 (10.04.2018) |

| Name and mailing address of the ISA/ | Authorized officer |
|---|---|
| Japan Patent Office 3-4-3, Kasumigaseki, Chiyoda-ku, Tokyo 100-8915, Japan | |
| | Telephone No. |

Form PCT/ISA/210 (second sheet) (January 2015)

**INTERNATIONAL SEARCH REPORT**

International application No.

PCT/JP2018/001590

C (Continuation). DOCUMENTS CONSIDERED TO BE RELEVANT

| Category* | Citation of document, with indication, where appropriate, of the relevant passages | Relevant to claim No. |
|---|---|---|
| A | WO 2015/122475 A1 (SEKISUI MEDICAL CO., LTD.) 20 August 2015 & US 2016/0349177 A1 & EP 3106859 A1 & CN 106164649 A | 1-15 |
| A | JP 2014-504380 A (IMRA AMERICA, INC.) 20 February 2014 & US 2012/0162748 A1 & WO 2012/087710 A1 & CN 103299494 A | 1-15 |
| A | JP 2001-296570 A (HITACHI, LTD.) 26 October 2001 & US 2001/0025924 A1 & US 2004/0240493 A1 | 1-15 |

Form PCT/ISA/210 (continuation of second sheet) (January 2015)

**INTERNATIONAL SEARCH REPORT**

International application No.

PCT/JP2018/001590

**Box No. II        Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III        Observations where unity of invention is lacking (Continuation of item 3 of first sheet)**

This International Searching Authority found multiple inventions in this international application, as follows:
See extra sheet

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**          ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (January 2015)

**INTERNATIONAL SEARCH REPORT**

| International application No. |
| --- |
| PCT/JP2018/001590 |

<Continuation of Box No. III>

Claims are classified into the following two inventions.

(Invention 1) Claims 1-13 and 15
Claims 1-13 and 15 have the special technical feature of an apparatus "provided with a light generating device comprising: a light source; a branching means for branching the light from the light source; a light-condensing lens for condensing the light from the branching means; and a mirror which reflects the light from the light-condensing lens and returns the light to the light source through a basic light-condensing lens and the branching means", and are thus classified as invention 1.

(Invention 2) Claim 14
Claim 14 cannot be considered to have special technical features identical or corresponding to those of claim 1 classified as invention 1.
Also, claim 14 is not dependent on claim 1. In addition, claim 14 is not substantially identical or equivalent to any of the claims classified as invention 1.
Therefore, claim 14 cannot be classified as invention 1.
Also, claim 14 has the special technical feature of an apparatus "provided with: an introduction tube which connects a carbon dioxide isotope-generating device and an optical resonator; a three port valve disposed on a carbon dioxide isotope-generating device side of the introduction tube; an introduction tube disposed on an optical resonator side of the introduction tube; a discharging tube which connects the optical resonator and a pump; and a discharging valve provided on the discharging tube", and is thus classified as invention 1.

Form PCT/ISA/210 (extra sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6004412 B

**Non-patent literature cited in the description**

- **S. DOBOS et al.** *Z. Naturforsch,* 1989, vol. 44a, 633-639
- *Applied Physics,* 1981, vol. 24, 381-386
- Designing of C continuous monitoring based on cavity ring down spectroscopy. **HIROMOTO KAZUO et al.** preprints of Annual Meeting. the Atomic Energy Society of Japan, 19 March 2010, 432
- *Hamamatsu Photonics K.K.,* 13243-011MA